Europäisches Patentamt

European Patent Office

Office européen des brevets

(11) Veröffentlichungsnummer: **0 344 513**
**A2**

## (12) EUROPÄISCHE PATENTANMELDUNG

(21) Anmeldenummer: 89108867.6

(22) Anmeldetag: 17.05.89

(51) Int. Cl.4: **H01J 9/02 , H01J 37/147**

(30) Priorität: 31.05.88 DE 3818535

(43) Veröffentlichungstag der Anmeldung:
06.12.89 Patentblatt 89/49

(84) Benannte Vertragsstaaten:
DE FR GB NL

(71) Anmelder: **Siemens Aktiengesellschaft**
**Wittelsbacherplatz 2**
**D-8000 München 2(DE)**

(72) Erfinder: **Lischke, Burkhard, Prof. Dr.**
**In der Heuluss 13**
**D-8000 München 82(DE)**
Erfinder: **Benecke, Wolfgang, Dr.**
**Sigismundstrasse 5**
**D-1000 Berlin 30(DE)**
Erfinder: **Schnakenberg, Uwe**
**Birkenstrasse 10**
**D-1000 Berlin 21(DE)**

(54) Verfahren zur Herstellung einer Steuerplatte für ein Lithographiegerät.

(57) Die mit einem erfindungsgemäßen Verfahren hergestellte Steuerplatte besteht im wesentlichen aus einem Halbleiterkörper (1) mit einem Fenster (10) zum Durchtritt der von einer Vielstrahlquelle ausgehenden Teilchensonden (14, 14') und einer entsprechenden Anzahl von Ablenkelementen (9, 9'), die über Bond-Pads (7, 7') und Verbindungsleitungen an die die Ansteuersignale erzeugende Elektronik des Lithographiegerätes angeschlossen sind. Zur Herstellung der auf dem mit einem Dielektrikum (2) beschichteten Halbleiterkörper (1) angeordneten Ablenkelemente (9, 9') werden lithographische Verfahren und galvanische Abformtechniken herangezogen.

FIG 1

EP 0 344 513 A2

## Verfahren zur Herstellung einer Steuerplatte für ein Lithographiegerät.

Die Erfindung bezieht sich auf ein Verfahren zur Herstellung einer Steuerplatte für ein Lithographiegerät nach dem Oberbegriff des Patentanspruchs 1.

Aus der US-A-4 724 328 ist ein Lithographiegerät (Elektronenstrahlschreiber) bekannt, dessen elektronenoptische Säule eine Aperturblende zur Erzeugung einer Vielzahl individuell ablenkbarer Elektronensonden aufweist. Die in der EP-O 191 439 AI näher beschriebene Aperturblende besteht im wesentlichen aus einer mit einer zeilenförmigen Mehrlochstruktur versehenen Siliziummembran, auf deren Oberfläche ein als Ablenkeinheit wirkendes Elektrodensystem angeordnet ist.

Der Erfindung liegt die Aufgabe zugrunde, ein Verfahren zur Herstellung einer Steuerplatte für ein Lithographiegerät anzugeben, wobei die mit einer Vielzahl von Teilchensonden beaufschlagte Steuerplatte eine Halbleitermembran und eine der Anzahl der Teilchensonden entsprechenden Anzahl von Ablenkelementen aufweist. Diese Aufgabe wird erfindungsgemäß durch ein Verfahren nach den Patentansprüchen 1 und 2 gelöst. Die Unteransprüche betreffen vorteilhafte Weiterbildungen der erfindungsgemäßen Verfahren.

Der mit der Erfindung erzielbare Vorteil besteht insbesondere darin, daß die mit dem erfindungsgemäßen Verfahren hergestellten Ablenkelemente mit den in der Mikroelektronik üblichen Steuerspannungen beaufschlagt werden können.

Die Erfindung wird im folgenden anhand der Zeichnungen näher erläutert. Hierbei zeigt

Figur 1 den schematischen Aufbau der herzustellenden Steuerplatte,

Figur 2 und 3 Prozeßfolgen zur Herstellung der Steuerplatte.

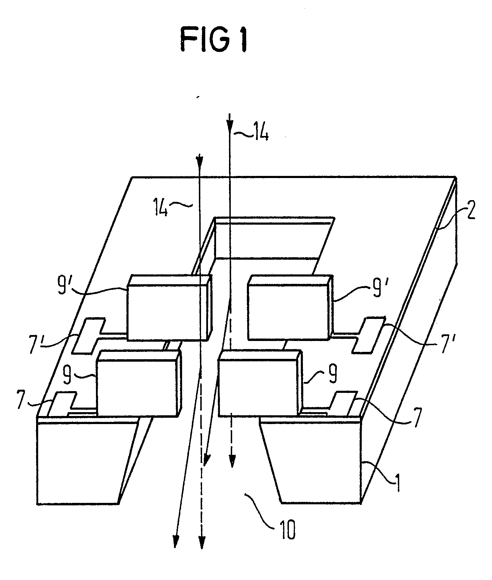

Die in Figur 1 schematisch dargestellte Steuerplatte besteht im wesentlichen aus einem einkristallinen Halbleiterkörper 1 mit einem Fenster 10 zum Durchtritt der von einer Vielstrahlquelle ausgehenden Teilchensonden 14, 14' und einer entsprechenden Anzahl von Ablenkelementen 9; 9' die über Bond-Pads 7, 7' und Verbindungsleitungen an die die Ansteuersignale erzeugende Elektronik des Elektronen- oder Ionenstrahllithographiegeräts angeschlossen sind. Als Vielstrahlquelle kommt insbesondere eine mit Ausnehmungen versehene Blende in Betracht, die man oberhalb der Steuerplatte anordnet und mit einem großflächigen primären Teilchenstrahl beaufschlagt. Jeder der Teilchensonden 14, 14' ist ein Ablenkelement 9, 9' der Steuerplatte zugeordnet, mit dem man die jeweilige Teilchensonde 14, 14' individuell ablenken und gegebenenfalls austasten kann (Ablenkung der betreffenden Teilchensonde auf eine im Strahlengang unterhalb der Steuerplatte angeordnete Blende). Zur Herstellung der Ablenkelemente 9, 9' und der gegebenenfalls verstärkten Bondpads 7, 7' und Anschlußleitungen auf dem mit einem Dielektrikum 2 beschichteten Halbleiterkörper 1 werden vorzugsweise lithographische Verfahren und galvanische Abformtechniken herangezogen, wobei die Lithographie in Abhängigkeit von den Abmessungen und der Komplexität der zu erzeugenden Strukturen mit UV- oder Synchrotronstrahlung durchzuführen ist. Der Höhe der Ablenkelemente 9, 9' beträgt einige 10 $\mu$m, insbesondere 10 bis 100 $\mu$m, so daß mit den üblichen Steuerspannungen der Mikroelektronik gearbeitet werden kann.

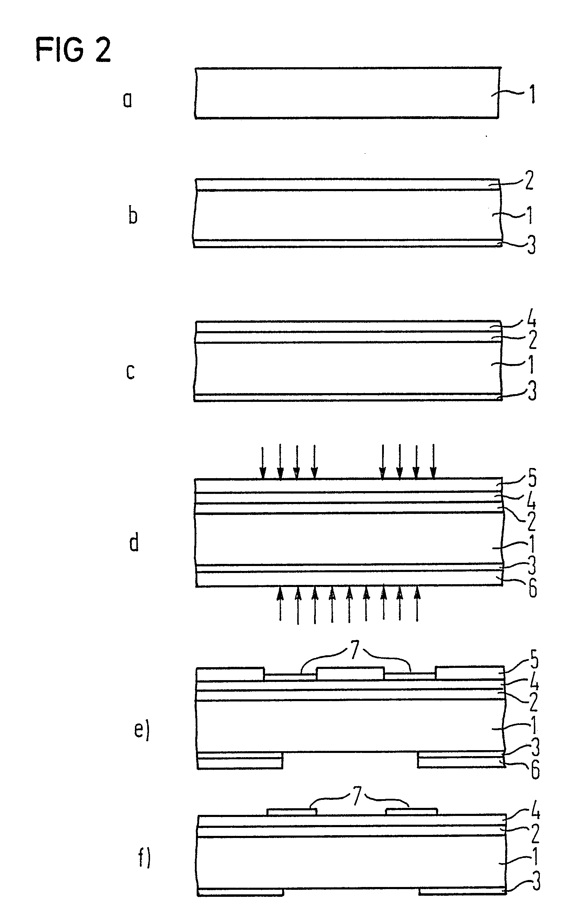

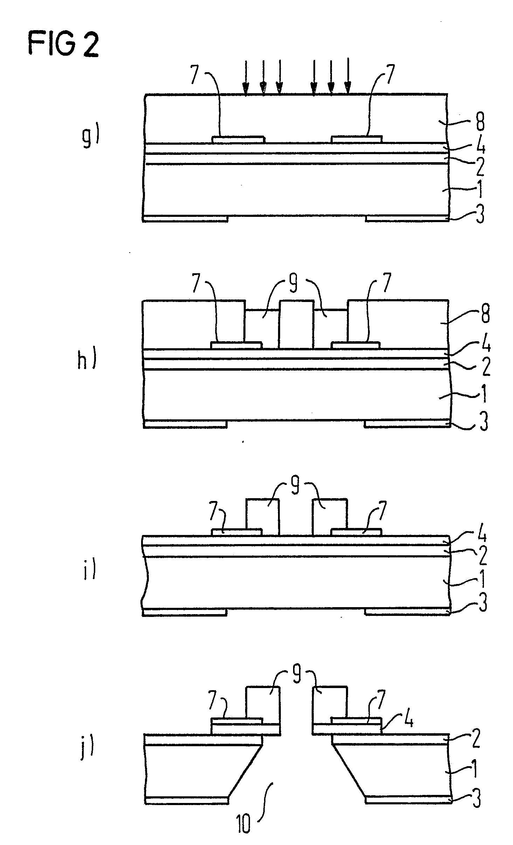

Der Prozeß zur Herstellung der in Figur 1 dargestellten Steuerplatte umfaßt erfindungsgemäß die folgenden Verfahrensschritte (siehe Figur 2):

- Abscheidung einer ersten dielektrischen Schicht 2, beispielsweise einer Siliziumnitrid- oder Siliziumoxidschicht, auf einem Halbleitersubstrat 1 beispielsweise Silizium mit (1, 0, 0)- oder (1, 1, 0)-Orientierung (Figur 2a, b).

- Abscheidung einer zweiten dielektrischen Schicht, beispielsweise einer Siliziumnitrid- oder Siliziumoxidschicht, auf der Substratunterseite (Figur 2b).

- Abscheidung einer metallischen Galvanik-Startschicht 4, beispielsweise einer Chrom-Gold- oder Titan-Goldschicht, auf der dielektrischen Schicht 2 (Figur 2c).

- Lithographische Übertragung der Geometrie der Substratdurchgangsöffnung 10 auf eine auf die dielektrische Schicht 4 aufgeschleuderte Photolackschicht 6 und Ätzen (Strukturierung) der dielektrischen Schicht 4 (Figur 2d, e).

- Lithographische Übertragung der Geometrie und Anordnung der Anschlußleitungen und der Bond-Pads 7, 7' auf eine auf die Galvanik-Startschicht 4 aufgeschleuderte Photolackschicht 5 (Figur 2d).

- Galvanische Verstärkung der Anschlußleitungen 7 und Entfernen der Photolackschicht 5 (Figur 2e, f).

- Beschichtung der Wafervorderseite mit einer Photolackschicht 8, deren Dicke größer ist als die gewünschte Höhe der zu formenden Ablenkelemente 9 (Figur 2g).

- Lithographische Übertragung der Geometrie und Anordnung der Ablenkelemente 9 auf die Photolackschicht 8 (Figur 2h).

- Galvanisches Auffüllen der in der Photolackschicht 8 erzeugten Vertiefungen bis zur gewünschten Höhe der Ablenkelemente 9 (Figur 2h).

- Entfernen der Photolackschicht 8 (Figur 2e).

- Anisotropes naßchemisches Ätzen des Halbleitersubstrats 1 auf der Waferrückseite zur Erzeugung der Substratdurchgangsöffnung 10 (Figur 2j).

- Ätzen der dielektrischen Schicht (2) und der Galvanik-Startschicht 4 im Bereich der Durchgangsöffnung 10 (Figur 2j).

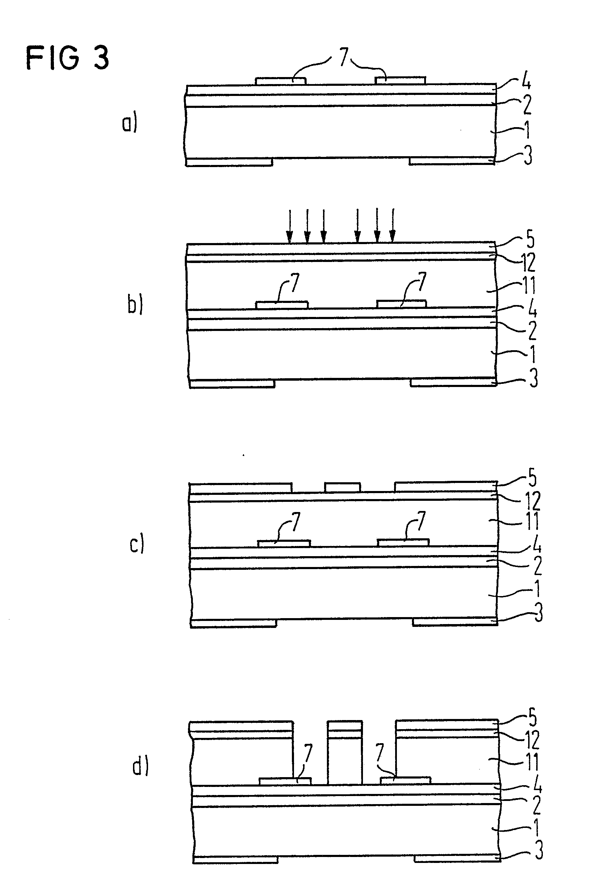

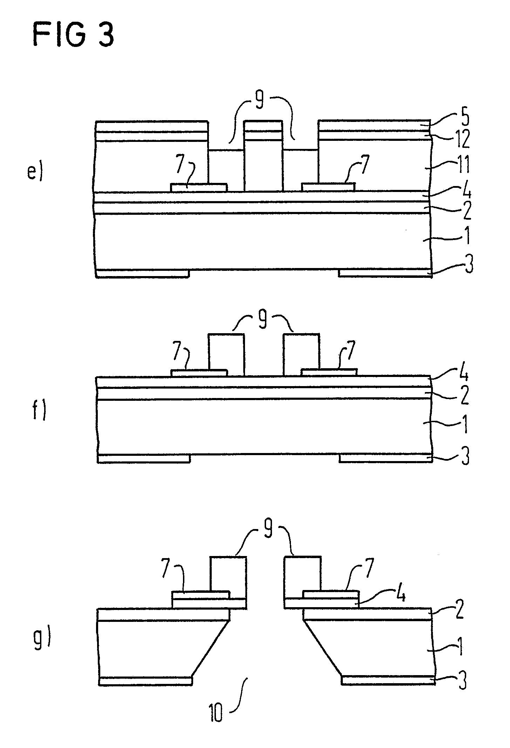

Gemäß weiterer Erfindung können die Ablenkelemente 9 auch durch Anwendung einer Dreilagentechnik hergestellt werden. Dieser Prozeß umfaßt dann die anhand der Figur 3 erläuterten Verfahrensschritte, wobei von der in Figur 2f dargestellten Struktur ausgegangen wird:

- Beschichtung der Wafervorderseite mit einem Lack oder Kunststoff 11 (beispielsweise Polyimid), dessen Dicke so bemessen ist, daß sie die Höhe der zu formenden Ablenkelemente 9 übertrifft (Figur 3a, b).
- Aufbringen einer zweiten Zwischenschicht 12, beispielsweise eine Aluminium- oder Siliziumnitridschicht.
- Lithographische Übertragung der Geometrie und Anordnung der Ablenkelemente 9 auf eine auf die Zwischenschicht 12 aufgeschleuderte Photolackschicht 5 (Figur 2b, c).
- Ätzen (Strukturieren) der Zwischenschichten 11 und 12 (Figur 3d).
- Galvanisches Auffüllen der in der ersten Zwischenschicht 11 erzeugten Vertiefungen bis zur gewünschten Höhe der Ablenkelemente 9 (Figur 3e).
- Entfernen der Photolackschicht 5 und der Zwischenschichten 11 und 12 (Figur 3f).
- Anisotropes naßchemisches Ätzen des Substrats 1 auf der Waferrückseite zur Erzeugung der Durchgangsöffnung 10 (Figur 3g).
- Ätzen der dielektrischen Schicht 2 und der Galvanik-Startschicht 4 im Bereich der Durchgangsöffnung 10 (Figur 3g).

**Ansprüche**

1. Verfahren zur Herstellung einer Steuerplatte für ein Lithographiegerät, wobei die mit einer Vielzahl von Teilchensonden (14, 14') beaufschlagte Steuerplatte eine Halbleitermembran (2) mit einer Ausnehmung (10) zum Durchtritt der Teilchensonden (14 14') und eine der Anzahl der Teilchensonden (14, 14') entsprechende Anzahl von Ablenkelementen (9, 9') aufweist, **dadurch gekennzeichnet,**
- daß ein Halbleitersubstrat (1) vorderseitig mit einer ersten dielektrischen Schicht (2) und rückseitig mit einer zweiten dielektrischen Schicht (3) versehen wird,
- daß eine metallische Schicht (4) auf der ersten dielektrischen Schicht (2) abgeschieden wird,
- daß die zweite dielektrische Schicht (3) entsprechend der Geometrie einer im Halbleitersubstrat (1) zu erzeugenden Durchgangsöffnungen (10) strukturiert wird,

- daß die Geometrie und Anordnung der zu erzeugenden Ablenkelemente (9, 9') auf eine auf die metallische Schicht (4) aufgebrachte Photolackschicht (8) lithographisch übertragen wird, wobei die Dicke der Photolackschicht (8) die Höhe der Ablenkelemente (9) übertrifft,
- daß die in der Photolackschicht (8) erzeugten Vertiefungen bis zur gewünschten Höhe der Ablenkelemente (9) galvanisch aufgefüllt werden,
- daß die Photolackschicht (8) entfernt wird,
- daß die Durchgangsöffnung (10) durch rückseitiges Ätzen des Halbleitersubstrats (1) erzeugt wird,
- und daß die metallische Schicht (4) und die erste dielektrische Schicht (2) im Bereich der Durchgangsöffnung (10) durch einen Ätzprozeß entfernt werden.

2. Verfahren zur Herstellung einer Steuerplatte für ein Lithographiegerät, wobei die mit einer Vielzahl von Teilchensonden (14, 14') beaufschlagte Steuerplatte eine Halbleitermembran (2) mit einer Ausnehmung (10) zum Durchtritt der Teilchensonden (14 14') und eine der Anzahl der Teilchensonden (14, 14') entsprechende Anzahl von Ablenkelementen (9, 9') aufweist, **dadurch gekennzeichnet,**
- daß ein Halbleitersubstrat (1) vorderseitig mit einer ersten dielektrischen Schicht (2) und rückseitig mit einer zweiten dielektrischen Schicht (3) versehen wird,
- daß eine metallische Schicht (4) auf der ersten dielektrischen Schicht (2) abgeschieden wird,
- daß die zweite dielektrische Schicht (3) entsprechend der Geometrie einer im Halbleitersubstrat (1) zu erzeugenden Durchgangsöffnung (10) strukturiert wird,
- daß die metallische Schicht mit einer ersten (11) und einer zweiten Zwischenschicht (12) überzogen wird, wobei die Dicke der ersten Zwischenschicht (11) so bemessen ist, daß diese die Höhe der zu formenden Ablenkelemente (9) übertrifft,
- daß die Geometrie und Anordnung der zu erzeugenden Ablenkelemente (9) auf eine auf die zweite Zwischenschicht (12) aufgebrachte Photolackschicht (5) lithographisch übertragen wird,
- daß die Struktur der Photolackschicht (5) durch einen Ätzprozeß auf die erste und die zweite Zwischenschicht (11, 12) übertragen wird,
- daß die in der ersten Zwischenschicht (11) erzeugten Vertiefungen bis zur Höhe der Ablenkelemente (9) galvanisch aufgefüllt werden,
- daß die Photolackschicht (5) und die Zwischenschichten (11. 12) entfernt werden,
- daß die Durchgangsöffnung (10) durch anisotropes Ätzen des Halbleitersubstrats auf der Waferrückseite erzeugt wird,
- und daß die erste dielektrische Schicht (2) und die metallische Schicht (4) im Bereich der Durch-gangsöffnung (10) durch einen Ätzprczeß entfernt werden.

3. Verfahren nach Anspruch 1 oder 2, **dadurch gekennzeichnet,** daß das Halbleitersubstrat (1) aus Silizium besteht, wobei das Silizium eine (1, 0, 0)-Orientierung aufweist.

4. Verfahren nach Anspruch 1 oder 2, **dadurch gekennzeichnet,** daß das Halbleitersubstrat (1) aus Silizium besteht, wobei das Silizium eine (1, 1, 0)-Orientierung aufweist.

# FIG 1

# FIG 2

# FIG 2

# FIG 3

# FIG 3